Europäisches Patentamt

European Patent Office

Office européen des brevets

(11) Publication number: **0 086 008**
**A2**

(12) **EUROPEAN PATENT APPLICATION**

(21) Application number: **83200122.6**

(22) Date of filing: **26.01.83**

(51) Int. Cl.³: **H 01 S 3/23**

(30) Priority: **04.02.82 NL 8200414**

(43) Date of publication of application:
**17.08.83 Bulletin 83/33**

(84) Designated Contracting States:
**AT DE FR GB IT NL**

(71) Applicant: **N.V. Philips' Gloeilampenfabrieken**
**Groenewoudseweg 1**
**NL-5621 BA Eindhoven(NL)**

(72) Inventor: **Tijburg, Rudolf Paulus**
**c/o INT. OCTROOIBUREAU B.V. Prof. Holstlaan 6**
**NL-5656 AA Eindhoven(NL)**

(72) Inventor: **Van Dongen, Teunis**
**c/o INT. OCTROOIBUREAU B.V. Prof. Holstlaan 6**
**NL-5656 AA Eindhoven(NL)**

(74) Representative: **Voorrips, Hugo Carel et al,**
**INTERNATIONAAL OCTROOIBUREAU B.V. Prof.**
**Holstlaan 6**
**NL-5656 AA Eindhoven(NL)**

(54) Semiconductor device for generating at least two radiation beams.

(57) A semiconductor device for generating at least two radiation beams (1, 2) of preferably different frequency comprises a substrate (3) on which according to the invention at least one LED or laser is provided on each side by epitaxial growth. The radiation beams are preferably parallel to each other and are preferably generated by double hetero junction (DH) lasers.

Application in DRAW (Direct Read And Write) and in DOR (Direct Optical Recording) systems.

FIG.1

EP 0 086 008 A2

"Semiconductor device for generating at least two radia-
tion beams".

The invention relates to a semiconductor
device for generating at least two radiation beams comprising a semiconductor substrate having substantially
parallel first and second main surfaces and a layer structure which is epitaxially grown on this substrate and comprises at least a first and a second pn-junction which, at
sufficiently high currents in the forward direction, each
generate in the adjoining semiconductor material one of
said radiation beams having a direction parallel to the
main surfaces.

A semiconductor device of the kind described above is known from Applied Physics Letters, Vol.35,
No. 8, October 15$^{th}$ 1979, p. 588 - 589.

For various applications it is of importance that two radiation sources are available which are
spaced apart by a small distance.

An important application is when information is optically recorded on discs ("Digital Optical
Recording" or DOR), in which process holes are burned into
a reflecting layer by means of a laser beam. In order to
check whether the information thus inscribed is correct,
this information is read out by means of a second laser
directly arramged behind the first laser according to the
so-called DRAW ("Direct Read And Write") system. The two
radiation beams may then have the same frequency, although
for reasons of switching technique it is desirable for the
separation of signals that the beams have a different radiation frequency.

This may be effected by means of a second
laser mounted in a separate optical holder or "light pen",
but this construction is expensive.

Alternatively, the radiation beam of a
single laser may be split up by means of an optical system into a "writing" beam and a "reading" beam. However, this is not economical since the "writing" process already requires a large amount of energy and the power of the laser must be further increased due to the splitting-up of the radiation beam, which gives rise to problems, _inter alia_ as to cooling and cost price.

It is also possible to use two separate lasers mounted on the same cooling plate. For this purpose, however, the lasers should be very accurately aligned with respect to each other, whilst the minimum distance between the emitting facets is at least equal to the width of each of the laser crystals.

Another application of a semiconductor radiation source with two or more radiation beams is found in the field of optical communication, in which light signals from a semiconcuctor radiation source (LED or laser) are coupled into an optical fibre for the transmission of information, which is read out at the other end of the optical fibre by means of a radiation detector. The quantity of information (the number of telephone calls, for example) which can be simultaneously be transported through the same optical fibre, can be doubled or multiplied by using a radiation source which emits two or more different frequencies; this is known as "wave length multiplexing".

The invention has for its object to provide a semiconductor device of a simple construction having at least two radiation-emitting diodes which are formed in the same semiconductor body and are spaced apart by a small and accurately reproducible distance.

The invention is based _inter alia_ on the recognition of the fact that it is possible to grow a layer structure comprising two light-emitting diodes or lasers in a manner such that the relative distance of the emitting facets in vertical direction, that is to say at right angles to the main surfaces, is determined by the thickness of one or more of the semiconductor layers and consequently can be comparatively small and very accurately defined.

According to the invention, a semiconductor device of the kind described in the opening paragraph is thereforecharacterized in that a first layer structure comprising the first pn-junction is grown on the first main surface and a second layer structure comprising the second pn-junction is grown on the opposite second main surface of the substrate.

The semiconductor device according to the invention has the important advantage that the regions in which the radiation is generated are spaced apart, at least in the vertical direction, by a small and accurately defined distance which is determined by the overall thickness of the intermediate semiconductor layers and hence mainly by the thickness of the substrate. Furthermore, the electrical series resistance of the radiation-emitting diodes is small due to the comparatively large thickness of the substrate.

Since the layer structures on each side of the substrate may be different both as to the layer thicknesses and as to the semiconductor materials used, the light-emitting diodes and lasers, respectively, may emit, if desired, radiation of a different frequency, which in certain applications is of importance, as stated above.

Although the LED's or lasers formed on each side of the substrate may emit radiation beams which make a more or less large angle with one another or even are at right angles to one another, it is advantageous for most applications that the emitted radiation beams are substantially parallel to each other. The device then preferably comprises substantially parallel strip-shaped active semiconductor regions, which emit the said radiation beams.

The strip-shaped active regions may coincide in projection, as a result of which their relative distance is a minimum. According to a preferred embodiment, however, the active regions do not overlap each other in projection. The main flow of heat of one diode then lies outside the other diode, which improves the cooling, whilst due to the somewhat larger distance between the emitting facets the radiation beams can be more readily coupled into two separated optical fibres.

The layer structure may constitute on one side or on both sides of the substrate a light-emitting diode which emits a non-coherent radiation beam. However, the invention is of particular importance for the aforementioned application of optically writing and reading information. For this application it is necessary that each of the said pn-junctions is located inside a resonator and forms part of a semiconductor laser. This resonator is preferably constituted by two substantially parallel reflecting ide surfaces which are substantially at right angles to the two main surfaces.

Although in this case the lasers formed on each side of the substrate may have diffused or even alloyed pn-junctions, it is generally advantageous that each semiconductor laser comprises an active layer which is formed between two passive layers of opposite conductivity types having a larger energy gap than the active layer, the passive layers of the two lasers located on the side of the substrate having the same conductivity type as the substrate.

The invention will now be described more fully with reference to an embodiment and the drawing, in which:

Figure 1 shows partly in cross-sectional view and partly in perspective view a semiconductor device according to the invention, and

Figures 2 to 7 inclusive show diagrammatically in cross-section the device of Figure 1 in successive stages of manufacture.

The Figures are schematic and not drawn to scale, whilst for the sake of clarity in particular the dimensions in the direction of thickness are shown relatively too large. Corresponding parts are designated by the same reference numerals.

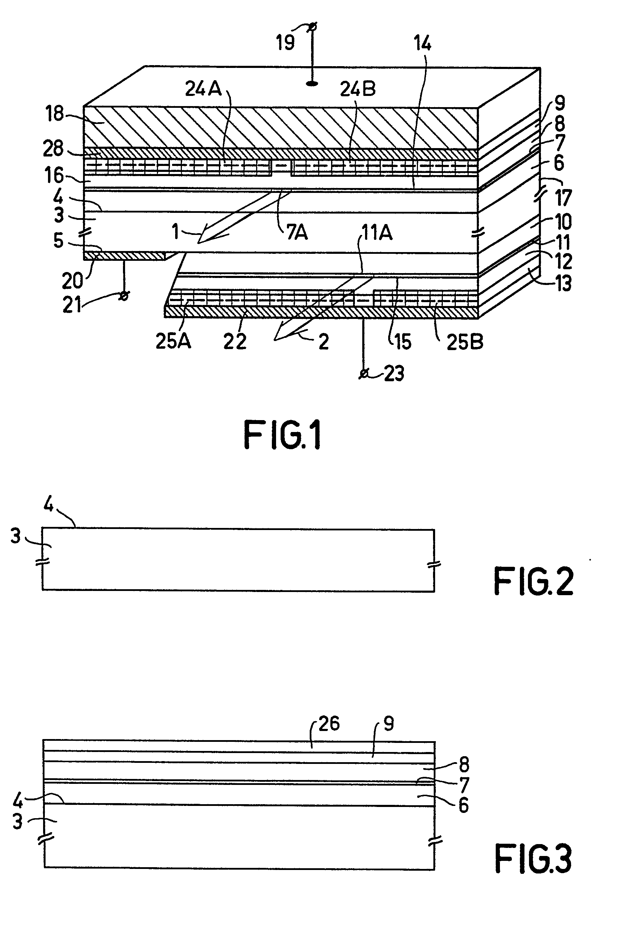

Figure 1 shows partly in cross-sectional view and partly in perspective view a semiconductor device according to the invention with which two radiation beams 1 and 2 can be generated. The semiconductor device comprises a semconductor substrate 3, which in this example consists of gallium arsenide. The substrate 3 has a first main surface 4 and a second main surface 5, which main surface are substantially parallel.

On the substrate 3 there is epitaxially grown a layer structure consisting of the layers 6 to 13 inclusive. This layer structure comprises a first pn-junction 14 and a second pn-junction 15- Each of these pn-junctions 14 and 15, at a sufficiently high current in the forward direction, can generate in the adjoining semiconductor material of the layers 7 and 11 one of the said radiation beams 1 and 2 in a direction parallel to the main surfaces 4 and 5.

According to the invention, a first layer structure (6, 7, 8, 9), which comprises the first pn-junction 14, is grown on the first main surface 4, whilst a second layer structure (10, 11, 12, 13) comprising the second pn-junction 15 is grown on the opposite main surface 5 of the substrate.

The distance between the two active layers 7 and 11, in which the radiation is generated, in this construction is defined by the overall thickness of the intermediate layers. Since the epitaxial layers have thicknesses of the order of 2 $\mu$m or less, the said distance is mainly determined by the thickness of the substrate 3, which is a few tens of $\mu$m.

In this example, the radiation beams 1 and 2 are substantially parallel, whilst they have a different radiation frequency. In air or _in vacuo_ the beam 1 has a wave length of approximately 820 nm, while the beam 2 has a wave length of approximately 870 nm.

The two active layers 7 and 11 in this example have substantially parallel strip-shaped active parts 7A and 11A, which are shown in Figure 1 in cross-section. The longitudinal direction of the strip-shaped active parts 7A and 11A is then at right angles to the plane of the drawing. These strip-shaped active parts 7A and 11A do not overlap each other in projection at right angles to the main surfaces 4 and 5. Moreover, the main heat flows of these active parts do not coincide, which is favourable for the cooling of each diode.

In the embodiment described here, each of the pn-junctions 14 and 15 forms part of a semiconductor laser and is located inside a resonator which is constituted by two substantially parallel reflecting side surfaces 16 and 17 of the crystal which are at right angles to the main surfaces and are constituted in this example by (110) cleavage surfaces. In this embodiment, both lasers are leasers of the so-called double hetero junction (DH) type. They each comprise an active layer (7, 11) which is provided between two passive layers of opposite conductivity type having a larger energy gap than the active layer. Thus, the active layer 7 is provided between the passive layers 6 and 8, whilst the active layer 11 is provided between the passive layers 10 and 12. In this example, the following materials, thicknesses and conductivity types were used:

| Layer: | Material: | Type: | Thickness: | Doping: |
|---|---|---|---|---|
| 3 (substrate) | GaAs | N | 80 $\mu$m | $7 \times 10^{17}$ Si at cm$^{-3}$ |
| 6 | $Al_{0.4}Ga_{0.6}As$ | N | 2 | $5 \times 10^{17}$ Sn |
| 7 | $Al_{0.9}Ga_{0.91}As$ | | 0.2 | undoped |
| 8 | $Al_{0.4}Ga_{0.6}As$ | P | 1.5 | $3 \times 10^{17}$ Ge |
| 9 | GaAs | P | 1 | $2 \times 10^{18}$ Ge |
| 10 | $Al_{0.3}Ga_{0.7}As$ | N | 2 | $5 \times 10^{17}$ Se |
| 11 | GaAs | | 0.2 | undoped |
| 12 | $Al_{0.3}Ga_{0.7}As$ | P | 1.5 | $10^{18}$ Zn |
| 13 | GaAs | P | 1 | $10^{18}$ Zn |

In the drawing it is assumed that the undoped active layers 7 and 11 are both weakly n-type conducting. They may also be weakly p-type conducting, in which event the pn-junctions 14 and/or 15 concerned are located on the other side of the active layer. The passive layers 6 and 10, which are located on the main surfaces of the substrate 3, naturally have the same (here N) conductivity type as the substrate.

The layer 9 is covered with an electrode layer 28, which is soldered on a cooling plate 18. The cooling plate 18 is provided with an electrical connection 19, while the substrate 3 is provided with an electrode layer 20 and a connection 21 and the layer 13 is provided with an electrode layer 22 and a connection 23, as is indicated in Figure 1. With the aid of the electrical connections 19, 21 and 23, a current can be applied in the forward direction both across the pn-junction 14 and across the pn-junction 15.

The width of the strip-shaped active parts 7A and 11A of the active layers 7 and 11 is determined in known manner by electrically substantially insulating regions 24A, 24B and 25A, 25B, which in Figure 1 are vertically cross-hatched and are obtained by a proton bombardment. Consequently, the current is substantially limited to the strip-shaped regions 7A and 11A.

The semiconductor device shown in Figure 1 can be manufactured in the following manner, see Figures 2 to 7 inclusive. The starting member (see Figure 2) is a substrate 3 of n-type gallium arsenide, the main surfaces of which have a (100) orientation and in which a large number of devices can be formed at the same time. In the Figures, only one of these devices is shown. The substrate originally has a thickness of approximately 300 $\mu$m and is doped with $7.10^{17}$ silicon atoms per $cm^3$. On a main surface 4 of the substrate there are deposited in a usual manner by means of epitaxial growth from the liquid phase the aforementioned layers 6, 7, 8 and 9 as well ass a p-type auxiliary layer 26 present thereon having the composition $Al_{0.4}Ga_{0.6}As$ and having a thickness of approximately 1 $\mu$m and a doping concentration of $10^{17}$ germanium atoms per $cm^3$, see Figure 3. For details of this known technique of growing from the liquid phase, which are not essential to the invention, those skilled in the art are referred to the book "Crystal Growth from High Temperature Solutions" of D.Elwell and JJ.Scheel, Academic Press 1975, p. 433 to 467 inclusive. The auxiliary layer 26 serves to protect the subjacent layers during the further treatment.

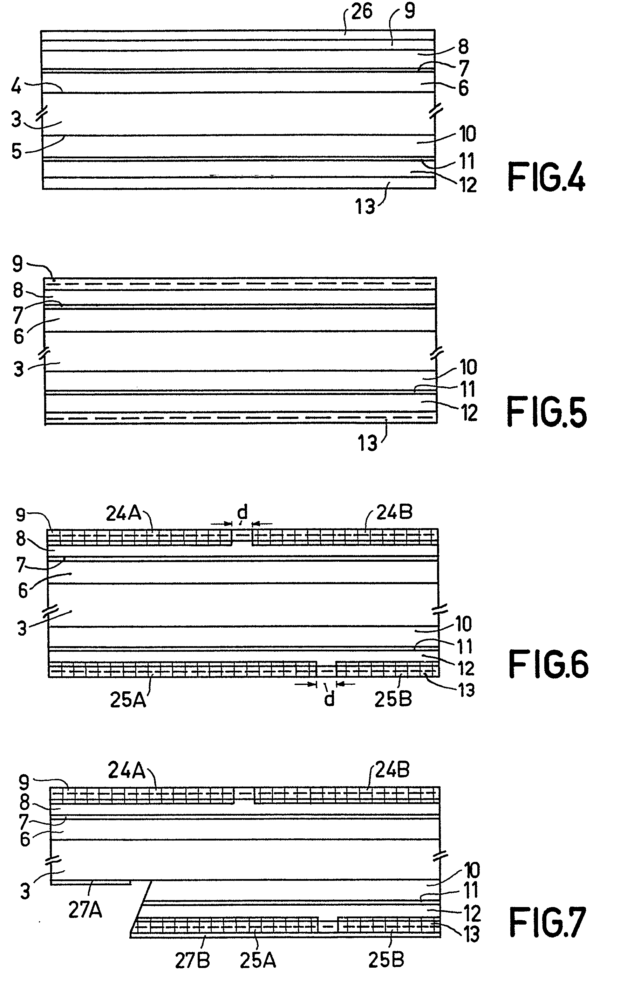

Subsequently, the substrate 3 is reduced in thickness on the side remote from the layer structure by chemomechanical polishing and etching, for example, to approximately 80 $\mu$m. On the second main surface 5 thus obtained a second layer structure comprising the layers 10, 11, 12 and 13 is then epitaxially deposited, see Figure 4. This can be effected in different manners according to generally known techniques. In this example, the layers 10 to 13 inclusive having the aforementioned composition, thickness and doping were deposited by epitaxial growth from the gaseous phase starting from metallo-organic compouns, such as trimethyl gallium, trimethyl aluminium and arsenic hydride. For this technique, known as "MO-CVD" technique ("Metal Organic Chemical Vapour Deposition") those skilled in the art are referred to, for example, the articles of R.D.Dupuis and P.D.Dapkus in Applied Physics Letters, vol. 31, no. 7, October 1st 1977, p. 466 - 468 and vol. 31, no. 12, December 15th 1977, where the necessary details, which are not essential to the invention, are given.

Subsequently, the auxiliary layer 26 is selectively removed by selective etching in, for example, a mixture of 50 ml of water, 1 ml of concentrated sulphuric acid, 1 ml of concentrated phosphoric acid, 2 g of chromium chloride ($CrCl_3.6H_2O$) and 0.1 g of $K_2Cr_2O_7$, the opposite side of the structure being masked. Due to the high p-type doping of the layer 26, the etching rate in the said etchant exceeds that of the layer 9 to such an extent that a good selective etching process is possible.

After the layer 26 has been removed, a zinc diffusion is carried out to a depth of approximately 0.6 $\mu$m. The diffusion depth is indicated in Figure 5 by a dotted line. This diffusion is carried out at 620°C for 30 minutes with zinc arsenide as the diffusion source in a capsule evacuated beforehand.

Subsequently, a proton bombardment is carried out, in which as a mask use is made, for example, of a tungsten wire. The proton bombardment is carried out at an energy of 100 keV and a dose of $10^{15}$ ions per $cm^2$. The electrically substantially insulating regions 24A,B and 25A,B thus obtained (see Figure 6) extend as far as a distance of approximately 1.5/um from the active layers 7 and 11. The width d of the strip-shaped interruptions in the regions 24 and 25, in which the tungsten wires were present, is in this example 4/um.

In order to be able to contact the substrate 3, the layer structure (10, 11, 12, 13) is then etched away through part of the surface of each device to be manufactured, see Figure 7. When a suitable etchant, for example, $Na_4OH$ (30%), $H_2O_2$ (30%) and water in equal parts by volume, is chosen, during the etching treatment an oblique edge surface with a (111) orientation is obtained if the direction of the edge is a (011) direction, see Figure 7. On this side, an electrode layer of, for example, gold, germanium and nickel having the composition 85% by weight of Au, 11% by weight of Ge and 4% by weight of Ni, can then be provided. Due to the "shadow effect" of the oblique edge separated metal layer portions 27A,B are then formed simultaneously on the substrate 3 and on the layer 13, see Figure 7. The portion 27B is then etched away, the portion 27A being masked by, for example, a photolacquer mask.

Subsequently, the portion 27A is alloyed into the substrate 3 by heating in order to obtain a good ohmic contact. Then there are successively provided on both sides of the semiconductor wafer without masking a 50 nm thick chromium layer, a 100 nm thick platinum layer and a 50 nm thick gold layer, the electrode layers thus obtained again constituting on the side of the layer structure (10, 11, 12, 13) separated parts due to the said "shadow effect". Ultimately, after the alloying process, the electrode layers 20, 22 and 28 of Figure 1 are obtained.

Subsequently, the cleavage surfaces 16 and 17 are obtained by scirbing and breaking, in which process a large number of laser devices can be formed one single semiconductor wafer. The devices thus obtained are each soldered with the electrode layer 28 to a cooling plate 18, for example, by means of an indium-containing soldering layer (not shown in the Figure). Finally, the device is finished in known manner.

The device thus obtained is particularly suitable for use in the process of optically writing and subsequently checking information, the aforementioned DRAW system. The laser constituted by the layers 6 to 9 inclusive, which has the larger power and therefore is secured directly on the cooling plate, is used for the writing operation, whilst the laser constituted by the layers 10 to 13 inclusive is used for reading out the recorded information.

The embodiment described here is given only by way of example. The invention is not limited at all to this embodiment, however. Many variations are possible within the scope of the invention. Thus, for example, other semiconductor materials and other layer thicknesses and dopings may be used. The conductivity types may all be replaced (simultaneously) by the opposite conductivity types. The laser or LED's provided on either side of the substrate may also have another construction than that described herein. In the extensive literature in the field of lasers and LED's, many possible variations thereof have been described. For example, one or both lasers may be of the TJS (Transfer Junction Stripe) type, which has been described *inter alia* in the United States Patent Specification no. 3,961,996. Instead of being defined by a proton bombardment, the strip-shaped active regions 7A and 11A may also be defined in another way, for example, by covering the laser surface with an insulating layer, in which at the area of the active region a strip-shaped opening is provided, which limits the region, in which the electrode layers 22 and 28 contact the layers 9 and 13, respectively. Furthermore, in cases in which a minimum distance between the emitting facets is desirable, the strip-shaped regions 7A and 11A may be located accurately opposite one another, although in this case the cooling is less satisfactory.

It should further be noted that the layers 6 to 9 inclusive and 10 to 13 inclusive of the embodiment described may also be formed with the aid of other growing techniques. For example, the layer structures on both sides of the substrate may be grown from the gaseous phase, whilst one or more layers may also be formed with the aid of the technique known as "Molecular Beam Epitaxy" or MBE.

Alternatively, besides the two lasers or LED's further semiconductor elements may be formed in the same semiconductor body. Thus, an integrated circuit for operating and/or stabilizing the light-emitting diodes may be formed in one or both layer structures in order to keep the connections between the diodes and the remaining part of the circuit arrangement as short as possible.

Finally, it should be noted that, instead of one on each side, several LED's or lasers may be provided on one or on both sides of the substrate if this is advantageous for certain applications.

CLAIMS

1.          A semiconductor device for generating at least two radiation beams comprising a semiconductor substrate having substantially parallel first and second surfaces and a layer structure which is grown epitaxially on this substrate and comprises at least a first and a second pn-junction which, at sufficiently high currents in the forward direction, each generate in the adjoining semiconductor material, one of said radiation beams having a direction parallel to the main surfaces, characterized in that a first layer structure comprising the first pn-junction is grown on the first main surface and a second layer structure comprising the second pn-junction is grown on the opposite second main surface of the substrate.

2.          A semiconductor device as claimed in Claim 1, characterized in that the said radiation beams are substantially parallel to each other.

3.          A semiconductor device as claimed in Claim 1 or 2, characterized in that the said radiation beams have a different radiation frequency.

4.          A semiconductor device as claimed in any of the preceding Claims, characterized in that the device comprises substantially parallel strip-shaped active semiconductor regions which emit the said radiation beams.

5.          A semiconductor device as claimed in Claim 4, characterized in that, in projection at right angles to the said main surfaces, the active regions do not overlap each other.

6.          A semiconductor device as claimed in any of the preceding Claims, characterized in that each of the pn-junctions is located inside a resonator and forms part of a semiconductor laser.

7.          A semiconductor device as claimed in Claim 6, characterized in that the resonator is constituted by two substantially parallel reflecting side surfaces which are substantially at right angles to the said main surfaces.

8.        A semiconductor device as claimed in Claim 6 or 7, characterized in that each semiconductor laser comprises an active layer which is provided between two passive layers of opposite conductivity type having a larger energy gap than the active layer, the passive layers of the two lasers located on the side of the substrate having the same conductivity type as the substrate.

FIG.1

FIG.2

FIG.3

0086008

**FIG.4**

**FIG.5**

**FIG.6**

**FIG.7**